Europäisches Patentamt

European Patent Office

Office européen des brevets

(11) Numéro de publication: **0 359 686**
**A1**

## (12) DEMANDE DE BREVET EUROPEEN

(21) Numéro de dépôt: **89430025.0**

(22) Date de dépôt: **08.09.89**

(51) Int. Cl.⁵: **H 05 K 13/06**
H 01 R 43/20, H 01 R 43/052

(30) Priorité: **15.09.88 FR 8812222**

(43) Date de publication de la demande:
**21.03.90 Bulletin 90/12**

(84) Etats contractants désignés:
**BE CH DE ES GB IT LI NL SE**

(71) Demandeur: **Ricard, Claude**
**Villa Sainte Madeleine 52, Cours Gambetta**
**F-13100 Aix-en-Provence (FR)**

(72) Inventeur: **Ricard, Claude**
**Villa Sainte Madeleine 52, Cours Gambetta**
**F-13100 Aix-en-Provence (FR)**

(74) Mandataire: **Azais, Henri et al**
**c/o CABINET BEAU DE LOMENIE "Prado-Mermoz" 232,**
**Avenue du Prado**
**F-13008 Marseille (FR)**

(54) **Procédés, dispositifs et pinces spécialisées pour insérer automatiquement les extrémités d'un faisceau de fils conducteurs sur un ensemble de composants.**

(57) L'invention a pour objet de procédés, des dispositifs et des pinces spécialisées permettant d'insérer mécaniquement les extrémités d'un faisceau de fils conducteurs sur les bornes ou dans les alvéoles d'un ensemble de composants électriques qui doivent être interconnectés par ces fils.

Un dispositif selon l'invention comporte un premier convoyeur (6) portant paires de pinces (2) qui tiennent chacune un tronçon de fil (3). Il comporte un convoyeur aller (10) et un convoyeur retour (12) de pinces spécialisées, des magasins verticaux $(9_1, 9_2, 9_3, 9_4)$ de pinces spécialisées placés entre ces deux convoyeurs, des cadreurs $(8_1, 8_2, 8_3, 8_4)$ qui transfèrent une par une chaque extrémité de fil en l'orientant du premier convoyeur (6) vers une pince spécialisée (11) portée par le convoyeur aller (10) et une tête d'insertion (13) qui saisit chaque pince spécialisée et qui la déplace axialement vers une palette (14) portant les composants (15) à interconnecter.

Une application est l'insertion mécanique des extrémités de fils conducteurs sur les bornes destinées à les recevoir.

Fig. 1

EP 0 359 686 A1

**Description**

**Procédés, dispositifs et pinces spécialisées pour insérer automatiquement les extrémités d'un faisceau de fils conducteurs sur un ensemble de composants.**

La présente invention a pour objet des procédés, des dispositifs et des pinces spécialisées pour insérer automatiquement les extrémités d'un faisceau de fils conducteurs sur les bornes ou dans les alvéoles d'un ensemble de composants.

Le secteur technique de l'invention est celui des travaux de câblage électrique. On connaît des machines de câblage automatiques qui sont construites par une unité de calcul centrale et qui réalisent des faisceaux de fils conducteurs en sélectionnant les fils, en sectionnant en tronçons de longueur déterminée puis en les dénudant et en sertissant sur certaines extrémités un terminal au pièce de connexion mâle ou femelle. Les fils sortent d'une telle machine par un convoyeur, par exemple un convoyeur qui porte une pluralité de pinces verticales dirigées vers le haut qui saisissent chacune l'extrémité d'un tronçon de fil lequel forme une demie boucle entre deux pinces successives.

Chaque faisceau de fils sortant d'une telle machine de câblage automatique est destiné à équiper un appareil électrique ou un sous-ensemble comportant une pluralité de composants munis de bornes ou d'alvéoles sur chacun desquels on doit insérer un des terminaux sertis sur l'extrémité de l'un des fils.

Dans certains cas les composants comportent des pièces de connexion dites à déplacement d'isolant dans lesquelles on doit insérer l'extrémité d'un fil non équipée en exerçant un effort suffisant pour sectionner la gaine isolante du fil qui doit être présenté perpendiculairement à la pièce de connexion.

L'objectif à atteindre, est d'arriver à effectuer automatiquement les opérations d'insertion de tous les terminaux d'un faisceau de fil sur les bornes d'un ensemble de composants destinées à les recevoir ; lesquels composants sont montés temporairement sur une platine support qui est elle-même placée sur une table motorisée qui peut se déplacer suivant deux axes trirectangulaires de façon à amener successivement chacune des bornes ou des alvéoles de l'ensemble des composants dans l'alignement d'une tête d'insertion automatique qui saisit chaque extrémité de fil et qui se déplace axialement pour insérer cette extrémité sur ladite borne ou dans ledit alvéole.

Un des problèmes qui se pose est dû à la diversité des terminaux qui peuvent être sertis sur les fils conducteurs d'un même faisceau. Certains de ces terminaux sont alignés avec le fil. D'autres, appelés terminaux en drapeau, sont perpendiculaires au fil comme un drapeau par rapport à sa hampe.

Dans l'autre cas, il s'agit d'insérer une extrémité de fil non équipée dans une pièce de connexion à déplacement d'isolant et dans ce cas le fil doit être présenté perpendiculairement à la pièce de connexion.

Ce problème est résolu selon l'invention d'une part en tenant les fils par des pinces spécialisées dont la forme est adaptée à celle du terminal et d'autre part en orientant automatiquement chaque extrémité de fil avant de l'engager dans une pièce spécialisée de telle sorte que la tête d'insertion puisse saisir toutes les pinces spécialisées de la même façon et insérer chaque terminal sur une borne ou chaque extrémité de fil sur une pièce de connexion à déplacement d'isolant dans la position voulue par un déplacement axial de la tête d'insertion accompagné éventuellement d'une rotation autour de l'axe de déplacement.

L'objectif de l'invention est atteint au moyen d'un procédé pour insérer automatiquement les extrémités d'un faisceau de fils conducteurs sur les bornes ou dans les alvéoles d'un ensemble de composants électriques qui sont montés sur une palette déplaçable suivant deux axes rectangulaires situés dans le plan de la palette, lesquels fils sont amenés, un par un, par un premier convoyeur, lequel procédé comporte les opérations suivantes :
- on transfère chaque extrémité de fil dans une pince d'insertion spécialisée et on transporte lesdites pinces spécialisées tenant chacune une extrémité de fil par jusqu'à une tête d'insertion qui saisit chaque pince spécialisée et la déplace axialement pour insérer l'extrémité du fil ou un terminal serti sur celle-ci sur une borne ou dans un alvéole d'un desdits composants qui est placé dans l'alignement de ladite tête d'insertion.

Avantageusement, on transfère chaque extrémité de fil dans une pince spécialisée en l'orientant de telle sorte que ladite pince le prenne et le maintienne dans une position où il peut être inséré par ladite tête d'insertion par un mouvement de translation axiale de celle-ci associé éventuellement à une rotation autour de son axe.

Selon un mode de réalisation préférentiel la tête d'insertion insère certains fils ou certains terminaux sur une borne ou dans un alvéole d'un desdits composants en exerçant en outre sur ladite pince spécialisée des percussions axiales.

Selon un mode de réalisation préférentiel les pinces d'insertion spécialisées sont transportées par un deuxième convoyeur qui est indépendant du premier et qui est entrainé pas à pas en synchronisme avec celui-ci.

Selon un deuxième mode de réalisation les pinces d'insertion spécialisées sont transportées par un convoyeur qui transporte les fils à la sortie d'une machine de câblage.

Un dispositif selon l'invention comporte :
- une palette , sur laquelle on fixe ledit ensemble de composants électriques , laquelle palette est montée sur un support motorisé déplaçable suivant deux axes rectangulaires situés dans le plan de ladite palette ;
- un premier convoyeur portant des paires de pinces dirigées vers le haut, qui tiennent chacune une des deux extrémités d'un tronçon de fil formant une dernière boucle dont les extrémités sont dirigées d'un même coté du convoyeur ;
- des pinces d'insertion spécialisées , - et une tête d'insertion qui est placée en regard de ladite palette , et qui comporte des moyens pour saisir une par une lesdites pinces d'insertion spécialisées et des moyens pour la déplacer dans une direction axiale (zz') perpendiculaire à ladite palette pour insérer un par un les terminaux sertis aux extrémités desdits fils ou pour insérer une par une les extrémités des fils sur les bornes desdits composants électriques.

Selon un premier mode de réalisation le premier convoyeur transporte les pinces spécialisées.

Selon un autre mode de réalisation un dispositif selon l'invention comporte un deuxième convoyeur, indépendant du premier, qui transporte les pinces d'insertion spécialisées jusqu'à la tête d'insertion.

Dans ce dernier cas, le premier et le deuxième convoyeur sont parallèles et sont entraînés pas à pas en synchronisme.

L'invention a pour résultat l'insertion par des moyens mécaniques des extrémités d'un faisceau de fils, équipés ou non d'un terminal, sur les bornes ou dans les alvéoles d'un ensemble de composants électriques que ledit faisceau doit interconnecter.

L'utilisation de pinces d'insertion spécialisées comportant un corps identique et des becs de préhension des fils adaptés au type de terminal ou à des fils non équipés présente de nombreux avantages. Elle permet de transférer toutes les extrémités d'un faisceau de fils sortant d'une machine automatique de câblage jusqu'à une tête d'insertion en utilisant un même convoyeur aller et un même convoyeur retour pour transporter toutes les pinces spécialisées. Elle permet également d'utiliser une même tête d'insertion pour insérer sur les bornes d'un ensemble de composants tous les types de terminaux qui sont nécessaires pour interconnecter ces bornes et qui varient selon les composants.

L'utilisation des pinces d'insertion spécialisées en combinaison avec un cadreur qui transfère les extrémités de fils une par une du convoyeur qui les amène vers les pinces spécialisées permet d'orienter chaque terminal ou chaque extrémité de fil non équipée pour la présenter dans la pince spécialisée dans la position voulue pour que la tête d'insertion n'ait plus qu'à saisir la pince spécialisée et à la déplacer axialement pour insérer le terminal ou l'extrémité du fil sur une borne ou dans un alvéole.

L'utilisation d'une tête d'insertion comportant des moyens de percussion permet d'engager les extrémités de fils non équipées d'un terminal dans une pièce de connexion à déplacement d'isolant sans avoir à exercer une poussée continue de l'ordre de 30 Kg qui risquerait de faire fléchir la palette portant les composants à interconnecter.

La description suivante se réfère aux dessins annexés qui représentent sans aucun caractère limitatif, un exemple de réalisation d'un dispositif selon l'invention et de pinces spécialisées destinés à équiper celui-ci.

La figure 1 est une vue d'ensemble en plan d'un dispositif selon l'invention.

Les figures 2, 3 et 4 sont des vues en plan, en élévation en coupe axiale d'un premier type de pince spécialisée.

La figure 5 est une vue de dessus d'un deuxième type de pince spécialisée.

La figure 6 est une vue en élévation d'une pince spécialisée pour insertion d'une extrémité de fil dans une pièce de connexion à déplacement d'isolant.

Les figures 7 et 8 sont une vue de face de l'insertion d'un fil dans une pièce de connexion à déplacement d'isolant.

La figure 9 est une coupe verticale selon IX IX de la figure 1.

La figure 10 est une vue en élévation d'un manipulateur-cadreur.

La figure 11 est une coupe selon XI XI de la figure 10.

La figure 12 est une coupe verticale selon XII XII de la figure 1.

La figure 13 est une vue de face de la figure 12.

La figure 14 est une coupe axiale d'une tête d'insertion.

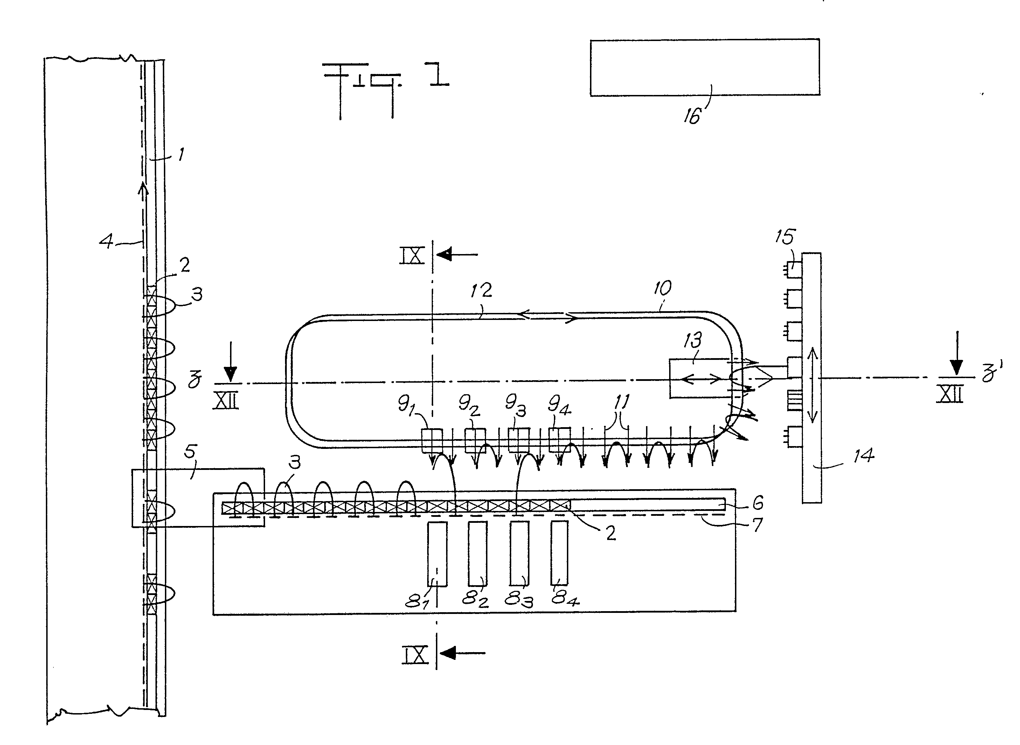

La figure 1 représente schématiquement une vue d'ensemble en plan d'un dispositif selon l'invention.

Le repère 1 représente un convoyeur, constitué par exemple par une courroie sans fin crantée qui porte, des pinces verticales 2 dirigées vers le haut. Chaque pince est montée sur un socle qui est engagé entre deux crans transversaux à la courroie.

Le convoyeur 1 est placé à la sortie d'une machine de câblage non représentée qui est conduite automatiquement par une unité de calcul centrale qui détermine la longueur et la nature de chaque tronçon de fil conducteur et la nature des terminaux que la machine sertit sur les extrémités de chaque tronçon de fil. Certaines extrémités de fil destinées à être insérées ultérieurement dans une pièce de connexion à déplacement d'isolant peuvent sortir de la machine sans aucun terminal.

Chacune des pinces 2 saisit une extrémité d'un tronçon de fil sortant de la machine et chaque tronçon de fil 3 forme une demie-boucle tenue par deux pinces successives, les extrémités des fils étant toutes perpendiculaires à la direction du convoyeur et situées du même coté de celui-ci.

Le dispositif comporte une deuxième courroie sans fin crantée 4 qui est représentée en tirets. La courroie 4 est parallèle à la courroie 1. Elle se déplace en sens inverse et sert à ramener les pinces vides à l'extrémité amont du premier convoyeur 1.

Le repère 5 représente un manipulateur par exemple un bras pivotant à 90 qui comporte des moyens de préhension simultanée d'une paire de pinces 2 portant un fil 3.

Le repère 6 représente un autre convoyeur analogue au convoyeur 1 et indépendant de celui-ci.

La figure 1 représente un convoyeur 6 perpendiculaire au convoyeur 1 mais cette disposition n'est pas limitative.

Le repère 7 représente en tirets un convoyeur de retour des pinces parallèle au convoyeur 6.

Selon un mode de réalisation le convoyeur aller 6 et le convoyeur retour 7 transportent non seulement des paires de pinces verticales 2 de préhension des deux extrémités d'un tronçon de fil mais également des pinces d'insertion spécialisées.

Dans ce cas, chaque extrémité de fil tenue par une des pinces de préhension 2 est transférée dans une pince d'insertion spécialisée qui est maintenue par ladite pince de préhension. Avantageusement dans ce cas, les pinces de préhension 2 et les pinces d'insertion (11) ont des formes complémentaires qui permettent de fixer une pince d'insertion dans une pince de préhension.

Par exemple, les pinces de préhension comportent deux alesages cylindriques et les pinces d'insertion comportent deux fiches mâles qui sont enfichés dans lesdits alesages cylindriques.

Dans ce cas le convoyeur de retour (7) est avantageusement situé au-dessus du convoyeur aller (6).

Les convoyeurs 1, 4, 6 et 7 sont entraînés pas à pas. Selon un mode de réalisation préférentiel le bras manipulateur 5 transfère du convoyeur 1 vers le convoyeur 6, une paire de pinces sur deux de sorte que le convoyeur 1 peut desservir un deuxième ensemble d'insertion identique non représenté sur le dessin.

Les repères $8_1$, $8_2$, $8_3$, $8_4$ représentent des dispositifs dits manipulateurs cadreurs qui sont disposés sur un des cotés du convoyeur 6 qui est celui où se trouvent les extrémités des tronçons de fils 3 portés par les pinces placées sur ce convoyeur. Ces manipulateurs cadreurs seront décrits en détail ci-après. Chaque manipulateur cadreur a pour fonction de saisir individuellement chaque extrémité de fil passant devant lui et comportant un terminal d'une catégorie déterminée. Par exemple le cadreur 8.1 saisit successivement toutes les extrémités de fil portant un terminal aligné avec le fil, le cadreur 8.2 saisit toutes les extrémités de fils portant un terminal en drapeau etc...

Les repères $9_1, 9_2, 9_3, 9_4$ représentent des magasins verticaux dans chacun desquels est stockée une catégorie de pinces spécialisées.

Les magasins $9_1, 9_2, 9_3, 9_4$ sont situés en face des manipulateurs cadreurs respectifs $8_1, 8_2, 8_3, 8_4$ de l'autre coté du convoyeur 6.

Le repère 10 représente un convoyeur aller de pinces spécialisées qui est parallèle au convoyeur 6 sur une partie de son parcours et qui passe sous les magasins $8_1, 8_2, 8_3$ et $8_4$.

Les convoyeurs 6 et 10 sont entraînés pas à pas en synchronisme.

Les repères 11 représentent des pinces d'insertion spécialisées de plusieurs formes, chaque forme étant destinée à saisir un type déterminé de terminal ou bien un fil sans terminal destiné à être engagé dans une pièce de connexion à déplacement d'isolant.

Le repère 12 représente un convoyeur retour qui ramène les pinces spécialisées vides vers les magasins $9_1, 9_2, 9_3, 9_4$.

Le repère 13 représente une tête d'insertion.

Le repère 14 représente une platine ou palette sur laquelle est monté provisoirement un ensemble de composants 15 qui sont équipés de bornes ou d'alvéoles sur lesquels la tête d'insertion 13 vient insérer automatiquement le terminal correspondant.

Le repère 16 représente une unité de calcul centrale qui commande automatiquement les divers actionneurs de la machine de câblage non représentée et du dispositif d'insertion automatique. L'unité centrale a en mémoire les caractéristiques des tronçons de fil qui se présentent à la sortie de la machine de câblage dans un ordre déterminé et elle sait quel type de terminal équipe chaque extrémité de fil et sur quelle borne ou dans quel alvéole de quel composant 15 ce terminal doit être inséré.

La palette 14 est montée sur une table motorisée qui est commandée par l'unité centrale 16 et qui déplace la palette suivant deux axes perpendiculaires O n et O y situés dans son plan et éventuellement suivant un troisième axe zz' perpendiculaire aux deux autres pour amener successivement chacune des bornes ou des alvéoles des composants 15 dans l'alignement de l'axe zz' qui est l'axe de la tête d'insertion 13.

La tête d'insertion est commandée par l'unité centrale 16. Elle se déplace en translation suivant l'axe zz1 et en rotation autour de cet axe.

Le fonctionnement général est le suivant. Le bras manipulateur 5 transfère une paire de pinces sur deux et le tronçon de fil 3 qu'elles tiennent sur le convoyeur 6. La vitesse du convoyeur 6 est généralement plus lente que celle du convoyeur 1, du fait qu'il faut prévoir entre chaque pas d'avancement un temps suffisamment long pour assurer les manutention de cadrage et de transfert des pinces spécialisées dans la tête d'insertion 13. Par exemple le convoyeur 6 assure un débit d'une extrémité de fil par seconde tandis que le convoyeur 1 transporte un fil par seconde.

En variante si les opérations de cadrage et de manutention des pinces spécialisées peuvent être accélérées ou si l'on peut ralentir la cadence de la machine de câblage automatique il n'est plus utile d'avoir deux convoyeurs 1 et 6.

Lorsqu'une extrémité de fil passe entre les manipulateurs cadreurs $8_1, 8_2, 8_3, 8_4$ et les magasins $9_1, 9_2, 9_3, 9_4$ l'unité centrale détermine quel est le type de terminal que porte cette extrémité de fil et quel est le manipulateur cadreur 8 qui doit la saisir et elle commande celui-ci. Le manipulateur cadreur saisit le terminal ou le fil dans le cas où il s'agit d'un fil sans terminal. Il ouvre la pince z qui tenait cette extrémité. Il fait pivoter éventuellement le terminal pour le présenter dans une position bien déterminée dans la pince spécialisée 11 qui se trouve libérée par le magasin 9 située en regard du cadreur 8, il introduit le terminal ou le fil dans la pince.

Toutes ces opérations de cadrage et de transfert ont lieu pendant que les deux convoyeurs 6 et 10 sont arrêtés entre deux pas d'avancement. Après quoi les convoyeurs avancent en entraînent la pince spécialisée 11 qui tient le terminal. Pendant un certain temps une des extrémités d'un fil est tenue par une pince d'insertion spécialisée portée par le convoyeur 6 et c'est pourquoi les deux convoyeurs avancent pas à pas, dans la même direction, en synchronisme.

Lorsque la pince d'insertion portée par le convoyeur 10 arrive devant la tête d'insertion 13 celle-ci la saisit et la déplace axialement suivant l'axe zz'pour insérer automatiquement le terminal tenu par la pince sur une borne ou dans un alvéole du composant 15 qui a été amené dans l'alignement de l'axe zz' et qui doit recevoir ce terminal. La tête d'insertion place la pince d'insertion vide sur le convoyeur de retour 12 qui la ramène vers le magasin $9_1,9_2,9_3,9_4$ correspondant à ce type de pince d'insertion.

Les figures 2 et 3 représentent respectivement une vue de dessus et une vue en élévation d'un premier type de pince d'insertion spécialisée pour des terminaux 17 sertis dans l'alignement du fil conducteur.

On a représenté à titre d'illustration un terminal 17 ayant la forme d'une cosse femelle à bords roulés mais cet exemple n'est pas limitatif. On voit que la pince d'insertion comporte deux becs $18_1,18_2$ qui sont placés à l'extrémité de deux tiges allongées $19_1,19_2$ en acier à ressort et qui saisissent le fil immédiatement à l'arrière du terminal ce qui permet d'insérer la totalité du terminal sur une borne mâle dans ce cas en poussant axialement.

Les pinces d'insertion diffèrent les unes des autres par la forme des becs constituant la pince. Par contre le corps de pince 20 est identique pour toutes les catégories de pinces d'insertion.

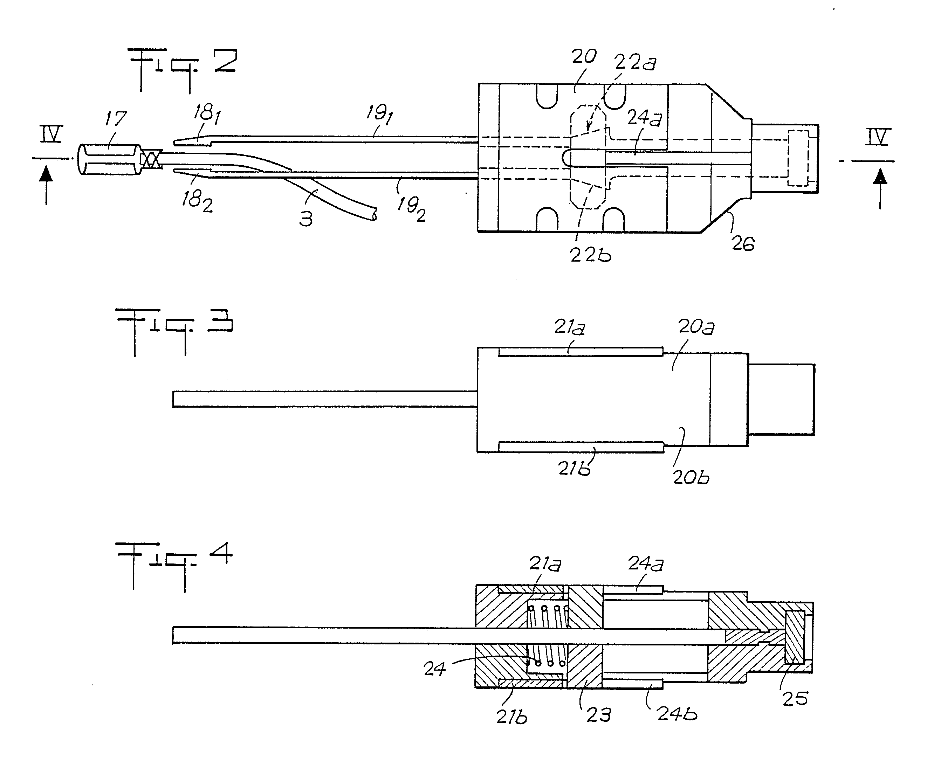

La figure 4 représente une coupe verticale du corps d'une pince. Ce corps est composé de deux demi-coquilles 20a, 20b visibles sur la figure 3 qui sont par exemple en matière plastique. Chaque demi-coquille porte une plaque en fer doux 21a, 21b qui set à la fixation de la pince sur des supports aimantés portés par les convoyeurs 10 et 12.

Les extrémités arrières des deux tiges $19_1,19_2$ comportent une rampe conique 22a, 22b visible sur la figure 2 et le corps de pince porte une bague coulissante 23 qui est poussée vers l'arrière par un ressort 24 de telle sorte que les deux becs de la pince sont maintenus normalement fermé par l'action de la bague 23 sur les deux rampes. Le corps de pince comporte deux fentes 24a, 24b parallèles à l'axe dans laquelle peuvent s'engager des doigts poussés par un vérin pour repousser la bague 23 vers l'avant ce qui a pour effet que les becs de la pince s'ornent par suite de l'élasticité des tiges $19_1,19_2$.

A l'extrémité arrière le corps de pince contient un aimant permanent 25 qui sert à maintenir la pince dans la tête d'insertion. On voit sur la figure 2 que le corps 20 comporte , à l'arrière, une partie tronconique 26 contre laquelle viendra s'appuyer un capteur de déplacement relatif fixé à la tête d'insertion pour permettre de détecter des défauts d'insertion des terminaux sur les bornes ou dans les alvéoles des composants 15.

La figure 5 représente une autre pince d'insertion spécialisée qui comporte une deuxième pince constituée par deux tiges $27_1,27_2$ qui sont plus longues que les tiges $19_1,19_2$ et qui portent à leur extrémité deux petites plaques $28_1,28_2$ qui guident latéralement le terminal au début de l'insertion. Les tiges $27_1,27_2$ sont poussées par un ressort de sorte que lorsqu'elles rencontrent le composant 15 elles se rétractent progressivement à l'intérieur du corps 20.

Les pinces selon les figures 2 à 5 peuvent être utilisées également pour insérer des terminaux connectés sur le fil en drapeau c'est-à-dire des terminaux dont la partie avant est perpendiculaire à la partie qui est sertie sur le fil.

La figure 6 représente une vue en élévation d'une pince spécialisée destinée à tenir une extrémité de fil une pour l'insérer dans une pièce de connexion dite à déplacement d'isolant.

Le corps de pince et les tiges selon les figure 19 sont identiques à ceux d'une pince selon les figures 2 à 4. Les becs de la pince sont plats pour saisir les fils 29. Le corps de pince porte une pièce 30 appelée marteau dont l'extrémité avant sert de butée au fil. Cette extrémité avant comporte deux fentes 31a, 31b. Les pièces de connexion à déplacement d'isolant portent deux couteaux 32a et 32b munis d'une fente qui découpent l'isolant lorsque le fil est engagé dans les fentes. Pendant l'insertion les deux fentes 31a et 31b du marteau sont positionnées en regard des deux couteaux 32a et 32b comme le montre la figure 6.

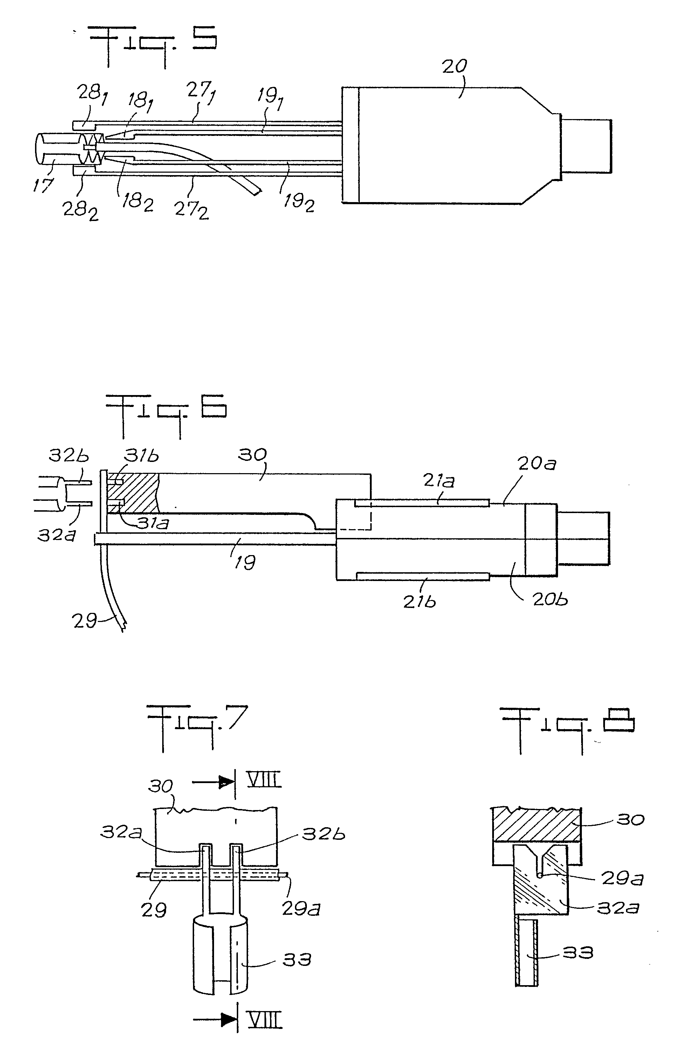

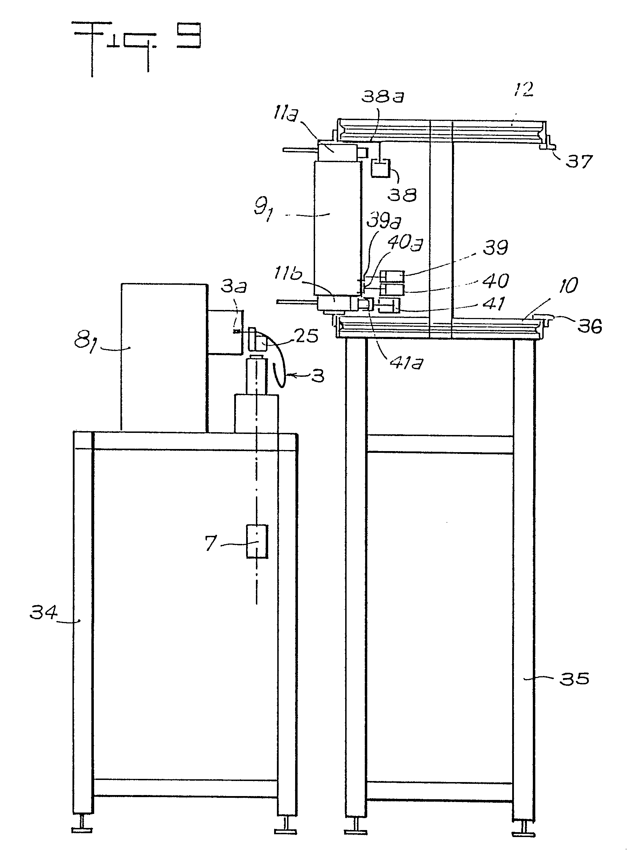

Les figures 7 et 8 représentent une pièce de connexion à déplacement d'isolant vue de face et de coté comportant par exemple une laine conductrice 33 ayant deux bords roulés qui est prolongée par deux couteaux 32a et 32b. On voit sur la figure 7 un fil 29 engagé dans les deux couteaux. On voit sur la figure 8 la forme des couteaux et le fil conducteur 29a placé dans la fente des couteaux qui assurent le contact entre le fil conducteur et la pièce de connexion.

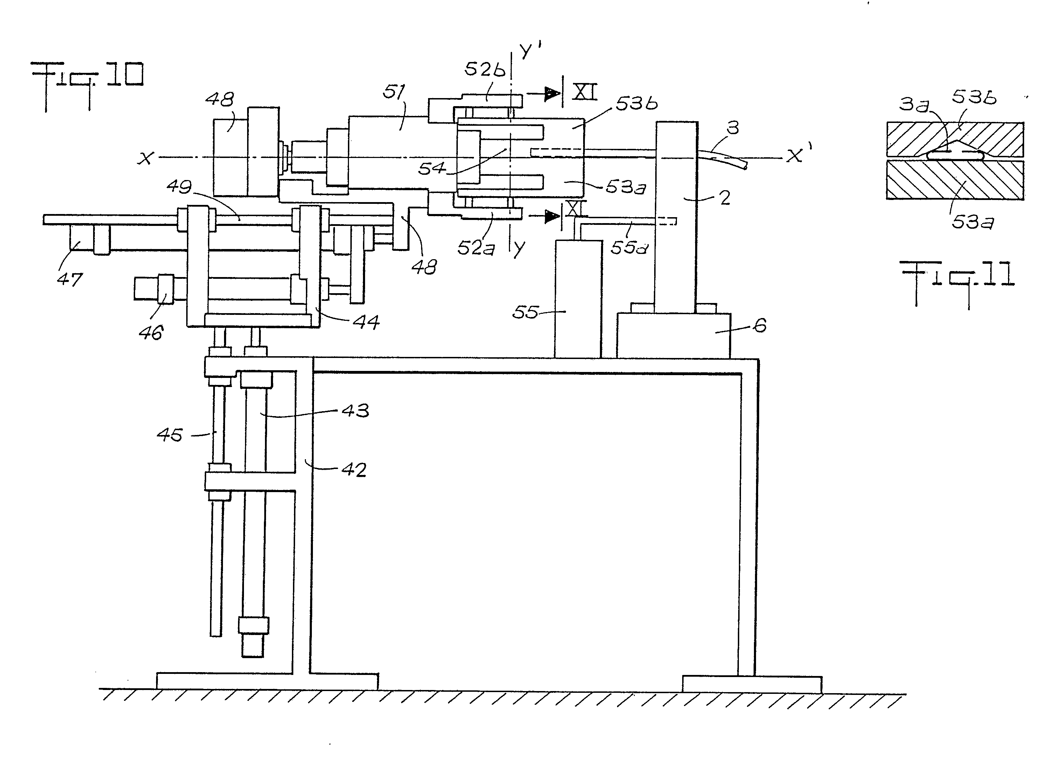

La figure 9 est une coupe selon IX IX de la figure 1. On voit sur cette figure un chassis métallique 34 portant le convoyeur aller 6 et le convoyeur retour 7 des pinces normales. On voit une pince 2 montée sur le convoyeur aller tenant un tronçon de fil 3 dont une extrémité est équipée d'un terminal 3a. Le repère 8.1 représente l'un des manipulateurs cadreurs qui est adapté à transférer une par une chaque extrémité de fil portant un type de terminal 3a déterminé.

Le repère 35 représente un deuxième chassis métallique qui porte le convoyeur aller 10 et le convoyeur retour 12 de pinces spécialisées. Le convoyeur retour 12 est situé au-dessus du convoyeur aller 10 et, entre les deux, se trouvent des magasins verticaux $9_1...9_4$ dans lesquels les pinces spécialisées qui retournent à vide par le convoyeur retour 12 sont stockées avant d'être reprises par le convoyeur aller 10. Chaque magasin $9_1...9_4$ correspond à un type de pinces spécialisées selon les figures 3 à 6. Chaque convoyeur 10, 12 est constitué par une courroie sans fin montée sur des poulies dont l'une est matrice. Le convoyeur aller 10 porte des petites plaques aimantées 36, disposées suivant un pas régulier, qui présentent une face plane horizontale dirigée vers le haut. De même le convoyeur retour 12 porte des plaques aimantées 37, disposées suivant un même pas régulier, qui ont une face plane horizontale dirigée vers le bas. Avantageusement les convoyeurs 10 et 12 tournent en sens inverse. Par exemple le convoyeur 10 tourne dans le sens inverse des aiguilles d'une montre tandis que le convoyeur 12 tourne dans le sens des aiguilles d'une montre.

Chaque magasin 9 comporte un boîtier cylindrique vertical dans lequel les corps des pinces spécialisées 11 sont empilés l'un au-dessus de l'autre. Ce boîtier comporte une fente verticale à travers laquelle passent les becs des pinces. On voit sur la figure 9 une pince 11a qui arrive au-dessus du magasin $9_1$.

Le corps de pince est suspendu à l'une des plaques aimantées 37 par la plaque en fer doux 21a du corps de pince qui est attirée par la plaque aimantée. Ce magasin comporte un vérin supérieur d'éjective 38 qui est équipé d'une tige coudée 38a qui se trouve placée au-dessus de la partie arrière du corps de la pince portée par le convoyeur retour. Le vérin 38 est commandé par l'unité centrale 16. L'actionnement du vérin appuie la tige coudée contre le corps de pince avec une force suffisante pour vaincre l'attraction de la plaque aimantée.

Chaque magasin 9 comporte à sa partie inférieure deux vérins superposés 39 et 40 qui sont munis de doigts 39a et 40a qui pénètrent dans le magasin. Ces deux vérins sont commandés alternativement par l'unité centrale 16. Ils servent à libérer la pince spécialisée 11 qui se trouve en bas du magasin en maintenant en place dans le magasin les autres pinces. La pince 11b qui est libérée vient se plaquer par sa plaque en fer doux 21b contre la plaque aimantée 36 portée par le convoyeur aller qui se trouve alors sous le magasin.

Le repère 41 représente un vérin d'ouverture des becs des pinces spécialisées qui équipe chaque magasin 9. La tige du vérin 41 porte deux doigts 41a qui pénètrent dans les fentes longitudinales 24a du corps de la pince spécialisée 11b pour repousser vers l'avant la bague conique 23 de sorte que les becs de pince s'ouvrent par l'action de l'élasticité.

Le fonctionnement est le suivant :
lorsqu'une extrémité de fil équipée d'un terminal 3a de type déterminé passe devant le manipulateur cadreur 8 qui correspond à ce type de terminal l'unité centrale 16 commande ce manipulateur cadreur et les vérins du magasin 9 qui est situé en regard de ce cadreur et qui contient les pinces spécialisées 11 correspondant à ce type de terminal.

Le manipulateur cadreur 8 saisit le terminal 3a. Il ouvre la pince 2 du convoyeur 6 qui tenait l'extrémité de fil. Il soulève le terminal pour échapper à la pince 2 qui se referme. Il fait éventuellement pivoter le terminal autour d'un ou de deux axes. Il se déplace ensuite en translation pour engager le terminal entre les becs de la pince spécialisée 11b qui sont alors ouverts. La pince spécialisée 11b se referme.

Le manipulateur cadreur recule et le convoyeur 10 avance d'un pas. Toutes les opérations du manipulateur cadreur ont lieu pendant le temps d'arrêt du convoyeur 10 et du convoyeur 6 entre deux pas d'avancement de ceux-ci.

Une extrémité d'un même tronçon de fil est tenue temporairement par une pince spécialisée portée par le convoyeur 10 tandis que l'autre extrémité est tenue par une pince 2 portée par le convoyeur 6, c'est pourquoi ces deux convoyeurs avancent pas à pas en synchronisme.

La figure 10 est une vue en élévation d'un manipulateur cadreur 8. Celui-ci comporte un bâti fixe 42 qui supporte un vérin vertical 43 qui déplace verticalement un support 44 qui est guidé par des tiges de guidage 45, par exemple par des colonnes à billes.

Le support 44 porte deux vérins horizontaux 46 et 47 qui déplacent horizontalement un support 48 qui est guidé par des tiges horizontales 49, par exemple des guides à bille.

Le support 48 porte un vérin rotatif 50 qui entraîne en rotation autour de l'axe horizontal xx' un ensemble cadreur qui comporte un vérin 51 qui entraîne deux bielles 52a et 52b ; lesquelles entraînent le cadreur en rotation autour de l'axe vertical yy'.

Le manipulateur cadreurs proprement dit comporte deux mâchoires, une mâchoire inférieure 53a et une mâchoire supérieure 53b entre lesquelles le terminal 3a ou l'extrémité d'un fil 3 sont pincés. Avantageusement la mâchoire inférieure 53a a une face supérieure plane tandis que la face inférieure de la machoire supérieure 53b a la forme d'un Vé renversé qui permet de centrer le terminal.

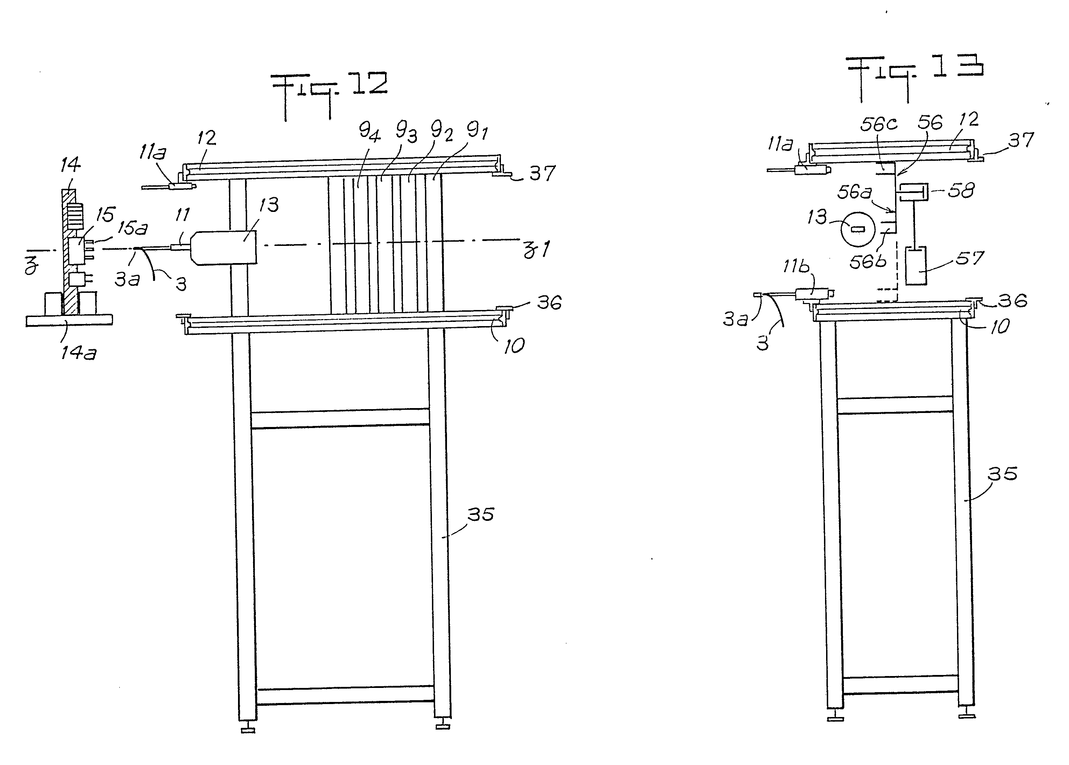

La figure 11 est une coupe de la figure 10 suivant X X sur laquelle on voit un terminal à bords roulés 3a tenu par les mâchoires 53a et 53b du manipulateur cadreur.

Le manipulateur cadreur comporte un vérin 54 qui commande l'ouverture et la fermeture des mâchoires 53a et 53b.

On a représenté de plus sur la figure 10 le convoyeur 6 et l'une des pinces 2 portées par ce convoyeur tenant une extrémité d'un tronçon de fil 3 qui est équipée d'un terminal 3a à bords roulés. Le repère 55 représente un vérin dont la tige 55a est pliée à angle droit et sert à ouvrir la pince 2. Les vérins 43, 46, 47, 48, 51, 54 et 55 équipant chaque manipulateur cadreur sont commandés par l'unité centrale 16.

Le fonctionnement du manipulateur cadreur est le suivant :
lorsqu'une extrémité d'un fil 3 tenu par une pince 2 se présente devant le manipulateur cadreur et que cette extrémité est équipé d'un terminal qui correspond à ce manipulateur cadreur, le vérin 46, déplace les mâchoires 53a, 53b parallèlement à l'axe xx' en position ouverte. Le vérin 54 commande la fermeture des machoires qui se referment sur le terminal. Le vérin 55 commande l'ouverture de la pince 2. Le vérin 43 soulève les mâchoires. Eventuellement les vérins 48 et 51 commandent des rotations autour des axes xx' et yy'pour amener le terminal 3a ou le fil à la pince spécialisée dans la position où il peut être inséré ultérieurement par un simple mouvement axial de la pince spécialisée. Le vérin 47 qui a une course plus longue que celle du vérin 46 déplace les mâchoires tenant le terminal 3a parallèlement à l'axe xx' pour amener l'extrémité du fil 3 entre les becs de la pince spécialisée 11b laquelle se referme sur le fil. Le vérin 54 ouvre alors les mâchoires 53a, 53b et les vérins 47, puis 43 les ramènent en arrière et au niveau de départ.

Si l'extrémité du tronçon de fil 3 est équipée d'un terminal aligné avec le fil aucune rotation autour des axes xx' et yy' n'est nécessaire.

Si l'extrémité du tronçon de fil 3 est équipée d'un terminal en drapeau on fait pivoter les mâchoires autour de l'axe xx' puis autour de l'axe yy' pour présenter le terminal en drapeau aux pinces spécialisées dans la position voulue.

Si l'extrémité du fil est une extrémité nue destinée à être insérée dans une pièce de connexion à déplacement d'isolant on saisit le fil entre les machoires 53a et 53b puis on fait pivoter l'ensemble cadreur d'abord autour de xx' puis autour de yy' pour engager le fil dans la pince spécialisée perpendiculairement à celle-ci.

La figure 12 est une coupe de la figue 1 selon XII XII. On retrouve sur cette figure le châssis 35 portant le convoyeur de pinces spécialisées aller 10 qui transporte les pinces spécialisées entre les magasins verticaux $9_1, 9_2, 9_3$ ou $9_4$ et la tête d'insertion 13, chaque pince tenant une extrémité de fil équipée ou non d'un terminal. On retrouve également le convoyeur retour 12 qui ramène les pinces spécialisées vides 11a de la tête d'insertion vers l'un des magasins $9_1, 9_2, 9_3$ ou $9_4$ selon le type de pince. On a représenté sur la figure 12 une palette ou platine 14 montée sur une table mobile 14a qui est déplaçable suivant deux axes rectangulaires contenus dans le plan de la palette et éventuellement suivant un troisième axe zz' perpendiculaire aux deux autres.

On a représenté sur la figure 12 une pince spécialisée 11 tenant un tronçon de fil 3 équipé d'un terminal 3a qui doit être inséré mécaniquement sur une borne male ou femelle 15 monté sur la palette 14.

La tête d'insertion 13 est déplaçable suivant l'axe zz1. Elle peut également pivoter autour de l'axe zz1.

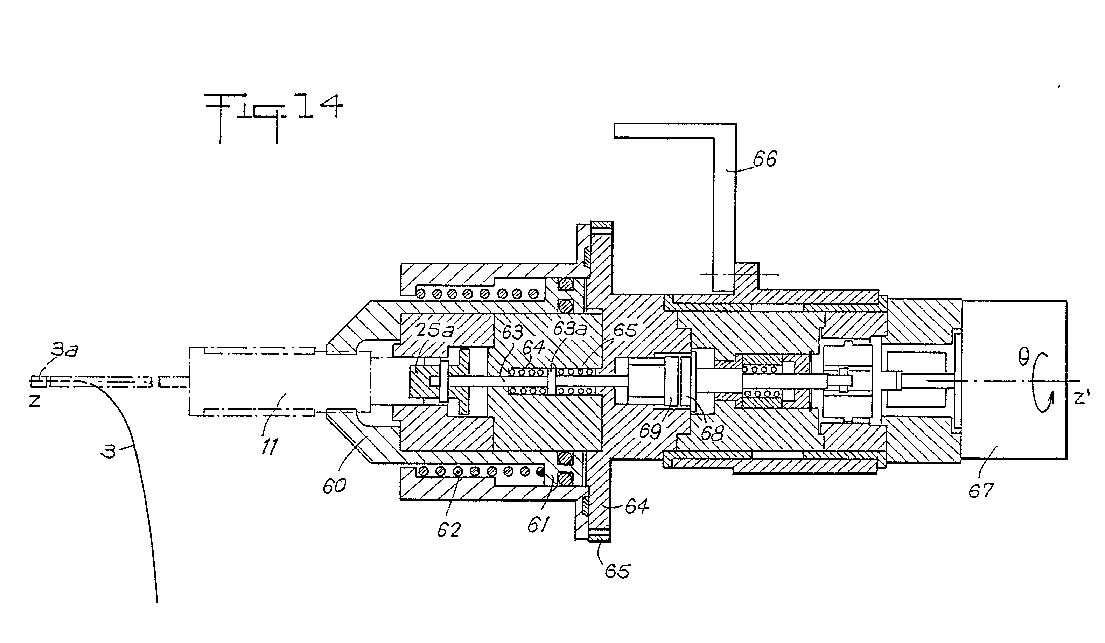

La figure 13 est une vue de gauche de la figure 12 sans la platine 14. On retourne sur cette figure le convoyeur 10 transportant les pinces spécialisées 11b qui tiennent chacune l'extrémité d'un fil 3, équipé ou non d'un terminal 3a. On y retourne également le convoyeur retour 12 qui transporte les pinces spécialisées vides. On voit sur cette figure la tête d'insertion 13 représentée schématiquement. On voit également un tiroir mobile 56 qui est associé à la tête d'insertion et qui est actionné par deux vérins 57 et 58. Le tiroir mobile comporte un bras vertical 56a dont la longueur est égale à la moitié de la distance entre les axes des pinces 11a et 11b. Ce bras 56a porte à chacune de ses extrémités une pince 56b, 56c dans laquelle vient s'engager une pince spécialisée. Le vérin 57 permet de déplacer verticalement le tiroir 56a pour l'amener dans la position représentée en pointillés. Ce vérin 58 permet de déplacer le tiroir 56a perpendiculairement à l'axe zz' de la tête d'insertion.

Lorsque le tiroir est en position basse la pince 56b s'engage latéralement sur une pince spécialisée 11b et sépare celle-ci de la plaque aimantée 36 à laquelle elle adhère magnétiquement. En même temps la pince supérieure 56a s'engage sur la pince spécialisée vide qui est engagée dans la tête d'insertion. Après quoi le tiroir 56 a reculé, le vérin 57 le déplace verticalement et le vérin 58 le fait à nouveau avancer. La pince inférieure 56b engage alors la pince spécialisée 11b portant une extrémité de fil dans la tête d'insertion tandis que la pince supérieure 56c vient placer la pince spécialisée vide contre une plaque aimantée 37 du convoyeur 12.

La figure 14 est une coupe axiale verticale de la tête d'insertion 13 tenant une pince spécialisée 11 conforme aux figures 2 à 4, laquelle pince spécialisée tient par ses becs une extrémité de fil 3 équipée d'un terminal 3a qui doit être inséré mécaniquement sur une borne. On voit, à l'avant de la tête d'insertion, deux doigts 60 qui pénètrent dans les fentes 24a, 24b du corps de la pince spécialisée. Les doigts 60 sont solidaires du piston 61 d'un vérin qui est repoussé vers l'arrière par un ressort 62 antagoniste de la poussée du fluide. Les becs de la pince 11 sont normalement fermés et on les ouvre en envoyant un fluide à l'arrière du piston 61. La pince 11 est maintenue dans la tête d'insertion par l'aimant 25 situé à l'arrière du corps de pince qui coopère avec une pièce en fer doux 25a portée par une tige axiale 63.

Le corps de la tête d'insertion porte à la périphérie une poulie 64 qui est entrainée en rotation autour de l'axe zz1 par une courroie crantée 65 ce qui permet d'orienter le terminal 3a en rotation par rapport à la borne sur laquelle il doit s'insérer. L'ensemble de la tête de rotation est porté par un châssis motorisé 66 qui est déplaçable parallèlement à l'axe zz' par un moteur linéaire non représenté.

On voit que la tige axiale 63 porte une collerette 63a qui est placée entre deux ressorts 64 et 65 prenant appui sur le corps de la tête d'insertion.

La tête d'insertion porte un capteur non représenté qui s'appuie contre la surface conique 26 située à l'arrière du corps de la pince spécialisée et qui mesure le déplacement relatif entre la pince spécialisée et la tête d'insertion.

Lorsque la tête d'insertion avance pour insérer le terminal 3a sur une borne, si le terminal rencontre un obstacle, le ressort 65 qui transmet la poussée de la tête à la pince spécialisée se comprime et la pince spécialisée recule par rapport à la tête d'insertion. Si le déplacement relatif dépasse un seuil, le capteur de déplacement relatif émet un signal de défaut qui peut déclencher une signalisation ou un arret automatique.

Lorsqu'un terminal a été inséré sur une borne, le support mobile 66 ramène la tête d'insertion en arrière, la pince spécialisée restant fermée. La tête d'insertion exerce donc une traction sur le fil 3 par l'intermédiaire du ressort 63. Si le terminal est bien inséré il résiste, le ressort 63 se comprime et le capteur de déplacement relatif ouvre automatiquement la pince lorsque le déplacement relatif atteint un seuil déterminé. Si ce seuil n'est pas atteint cela signifie que le terminal est mal inséré, la pince spécialisée n'est pas ouverte et le terminal 3a est alors retiré par la pince spécialisée.

La tête d'insertion comporte à l'extrémité arrière un moteur 67, qui entraîne en rotation autour de l'axe zz' un disque 68 qui coopère avec un disque 69 porté par l'extrémité arrière de la tige 63. Les deux disques 68 et 69 forment une canne à échappement ou à chocs du même type que celles qui équipent les perceuses à percussion.

Lors des insertions de terminaux normaux les efforts d'insertion axiaux sont relativement faibles de l'ordre de 200g à 7 Kg. La palette 14 qui porte les composants 15 peut résister sans fléchir à de tels efforts sans se déformer. Par contre l'insertion d'un fil non équipé dans une pièce de connexion à déplacement d'isolant exige des efforts axiaux de l'ordre de 30 Kg et les palettes 14 ne sont pas prévues pour résister sans fléchir à de tels efforts continus à moins d'utiliser des palettes renforcées ce qui augmente les coûts.

Le dispositif à percussion permet d'éviter cette difficulté et constitue une des caractéristiques de l'invention.

Lorsqu'une pince spécialisée 11 tenant une extrémité de fil destiné à être inséré dans une pièce de connexion à déplacement d'isolant se présente, l'unité centrale 16 met le moteur 67 en route. Celui-ci entraîne le disque 68 qui est séparé du disque 69 par un espace intermédiaire.

Dès que l'invention commence, le ressort 65 se comprime et le disque 69 recule. Lorsqu'il arrive au contact du disque 68 les percussions ont lieu et, grâce à celles-ci, le fil est engagé dans les couteaux 32a, 32b de la pièce de connexion selon les figures 6 à 8 sans avoir à exercer une poussée continue d'intensité élevée.

**Revendications**

1. Procédé pour insérer automatiquement les extrémités d'un faisceau de fils conducteurs (3) sur les bornes ou dans les alvéoles d'un ensemble de composants électriques (15) qui sont montés sur une palette (14) déplaçable suivant deux axes rectangulaires situés dans le plan de la palette lesquels fils sont amenés un par un par un premier convoyeur (1) caractérisé en ce que l'on transfère chaque extrémité de fil dans une pince d'insertion spécialisée (11) et on transporte lesdites pinces spécialisées jusqu'à une tête d'insertion (13) qui saisit chaque pince spécialisée et qui la déplace axialement pour insérer l'extrémité du fil ou un terminal serti sur celle-ci sur une borne ou dans une alvéole d'un desdits composants (15).

2. Procédé selon la revendication 1 caractérisé en ce qu'on transporte les pinces spécialisées par un deuxième convoyeur (10) affecté aux pinces spécialisées, et indépendant du premier.

3. Procédé selon la revendication 1 caractérisé en ce qu'on transporte les pinces spécialisées par ledit premier convoyeur (1).

4. Procédé selon l'une quelconque des revendications 1 à 3 caractérisé en ce que l'on transfère chaque extrémité de fil dans une pince spécialisée (11) en l'orientant de telle sorte que ladite pince le prenne et le maintienne dans une position où il peut être inséré par ladite tête d'insertion (13) par un mouvement de translation axiale de celle-ci associé éventuellement à une rotation autour de son axe (zz').

5. Procédé selon l'une quelconque des revendications I à 4 caractérisé en ce que ladite tête d'insertion (13) insère certains fils ou certains terminaux sur une borne ou dans une alvéole d'un desdits composants (15) en exerçant en outre sur ladite pince spécialisée (11) des percussions axiales.

6. Dispositif pour insérer automatiquement les extrémités d'un faisceau de fils conducteurs (3) sur un ensemble de composants électriques (15) caractérisé en ce qu'il comporte :
- une palette (14), sur laquelle on fixe ledit ensemble de composants électriques (15), laquelle palette est montée sur un support motorisé déplaçable suivant deux axes rectangulaires situés dans le plan de ladite palette ;
- un premier convoyeur (6) portant des paires de pinces (11) dirigées vers le haut, qui tiennent chacune une des deux extrémités d'un tronçon de fil (3) formant une dernière boucle dont les extrémités sont dirigées d'un même coté du convoyeur ;
- des pinces d'insertion spécialisées (11),
- et une tête d'insertion (13) qui est placée en regard de ladite palette (14), et qui comporte des moyens pour saisir une par une lesdites pinces d'insertion spécialisées (11) et des moyens pour la déplacer dans une direction axiale (zz') perpendiculaire à ladite palette pour insérer un par un les terminaux sertis aux extrémités desdits fils ou pour insérer une par une les extrémités des fils sur les bornes desdits composants électriques.

7. Dispositif selon la revendication 6 caractérisé en ce qu'il comporte un deuxième convoyeur (10) indépendant du premier convoyeur (6) , qui transporte lesdites pinces d'insertion spécialisées et qui est entraîné, pas à pas, en synchronisme avec le premier convoyeur.

8. Dispositif selon la revendication 6 caractérisé en ce que ledit premier convoyeur (6) est associé à un convoyeur (7) de retour des pinces et ledit dispositif comporte des magasins verticaux (9₁,9₂,9₃,9₄) correspondant chacun à un type de pinces spécialisées (11) qui sont situés entre ledit premier convoyeur (6) et ledit convoyeur de retour (7).

9. Dispositif selon la revendication 7 caractérisé en ce que ledit deuxième convoyeur(10) est situé au-dessous d'un convoyeur de retour (12) et ledit dispositif comporte des magasins verticaux (9₁,9₂,9₃,9₄) correspondant chacun à un type de pinces spécialisées (11) qui sont situés entre ledit deuxième convoyeur (10) et ledit convoyeur de retour (12).

10. Dispositif selon l'une quelconque des revendications 8 et 9 caractérisé en ce qu'il comporte des manipulateurs cadreurs (8₁,8₂,8₃,8₄) qui sont disposés en regard de chacun desdits magasins verticaux (9₁,9₂,9₃,9₄) du même coté dudit premier convoyeur (6) que les extrémités des fils portés par lesdits pinces (2) et chacun desdits manipulateurs cadreurs saisit un par un, les terminaux (3a) d'un type donné ou les extrémités de fils (3) non équipées, les oriente et les engage entre les becs d'une pince spécialisée (11b) correspondant au même type de terminal qui est prélevée dans un desdits magasins (9₁,9₂,9₃,9₄).

11. Dispositif selon la revendication 10 caractérisé en ce que chacun desdits manipulateurs cadreurs (8₁,8₂,8₃,8₄) comporte un vérin (55) qui ouvre lesdites pinces (2) portées par le premier convoyeur, des mâchoires (53a, 53b) actionnées par un vérin (54) qui saisissent un par un lesdits terminaux (3a) ou les extrémités des fils non équipés, un vérin vertical (43) qui déplace lesdites mâchoires en hauteur, deux vérins horizontaux (46, 47) qui déplacent lesdites mâchoires suivant un axe horizontal (xx') et deux vérins (48, 51) qui font pivoter lesdits mâchoires respectivement autour dudit axe horizontal (xx') et autour d'un axe vertical (xx').

12. Dispositif selon l'une quelconque des revendications 7 et 9 caractérisé en ce que ladite tête d'insertion (13) est située à égale distance dudit deuxième convoyeur aller (10) et dudit convoyeur retour (12) et elle est associée à un tiroir (56) comportant deux pinces (56b, 56c) placées aux deux extrémités d'un bras vertical (56a) dont la longueur est égal à la moitié de la distance entre lesdits convoyeurs (10, 12) lequel bras est déplacé verticalement par un premier vérin (57) et horizontalement, dans une direction transversale à ladite tête d'insertion (13) par un deuxième vérin (58).

13. Dispositif selon l'une quelconque des revendications 6 à 12 caractérisé en ce que ladite tête d'insertion comporte, à l'avant, des doigts (60), poussés vers l'avant par un piston (61)) de vérin et vers l'arrière par un ressort (62) lesquels doigts s'engageant dans deux fentes (21a, 21b) du corps des pinces spécialisées (11) pour ouvrir celles-ci.

14. Dispositif selon l'une quelconque des revendications 6 à 13 caractérisé en ce que ladite tête d'insertion (13) est montée sur un support motorisé (66) déplaçable suivant l'axe (zz') de ladite tête d'insertion, et le corps de ladite tête d'insertion comporte une poulie (64) qui est entraînée par une courroie crantée (65) en rotation autour dudit axe (zz') de ladite tête d'insertion.

15. Dispositif selon l'une quelconque des revendications 6 à 14 caractérisé en ce que ladite tête d'insertion porte un moteur (67) qui entraîne en rotation une canne à chocs (68, 69) qui permet d'engager un fil non équiper dans une pièce de connexion à déplacement d'isolant en exerçant pendant l'insertion des percussions sur la pince spécialisée (11b) tenant ledit fil.

16. Pinces spécialisées pour dispositifs selon l'une quelconque des revendications 6 à 15 caractérisées en ce qu'elles ont toutes un même corps comportant un aimant (25) pour la maintenir dans la tête d'insertion (13) et des organes de préhension dont la forme correspond à un type de terminaux.

17. Pinces spécialisées selon la revendication 16 destinée à insérer des terminaux (17) alignés avec le fil (3) sur lequel il sont sertis caractérisées en ce qu'elles comportent deux becs allongés (18.1, 18.2, 19.1, 19.2) en acier élastique qui saisissent le fil (3) à l'arrière dudit terminal (17) et dont les extrémités arrières sont engagées dans une bague (23) poussée par un ressort (24) qui les maintient en position fermée et ledit corps (20) comporte deux fentes (24a, 24b) dans lesquelles viennent s'engager des doigts qui repoussent vers l'avant ladite bague pour ouvrir lesdits becs.

18. Pince spécialisée selon la revendication 17 caractérisée en ce qu'elle comporte, en outre, deux plaques de guidage (28.1, 28.2) situées en avant desdits becs (18.1, 18.2), à l'extrémité de deux tiges (19.1, 19.2) poussées par des ressorts lesquelles plaques servent à guider le terminal (17) au début de l'insertion.

19. Pince spécialisée selon la revendication 16 destinée à tenir une extrémité de fil (29) non équipée pour l'engager dans les couteaux (32a, 32b) d'une pièce de connexion à déplacement d'isolant caractérisée en ce qu'elle comporte en outre une plaque (30) qui sert de butée audit fil et qui porte deux fentes (31a, 31b) qui viennent se positionner en regard desdits couteaux (32a, 32b).

Fig. 1

Fig. 2

Fig. 3

Fig. 4

EP 0 359 686 A1

Fig. 5

$28_1$  $18_1$  $27_1$  $19_1$

20

17

$28_2$  $18_2$  $27_2$  $19_2$

Fig. 6

32b  31b  30

20a

21a

31a

19

21b  20b

29

Fig. 7

30  VIII

32a  32b

29  29a

33

VIII

Fig. 8

30

29a

32a

33

Fig. 9

Fig.10

Fig.11

Fig. 12

Fig. 13

Fig.14

**Office européen**
**des brevets**

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | FR-A-2555397 (ARTOS ENGINEERING COMPANY)<br>* page 21, ligne 1 - page 23, ligne 21;<br>revendication 26; figures 3, 5, 22, 30-33 *<br>--- | 1, 6 | H05K13/06<br>H01R43/20<br>H01R43/052 |
| A | FR-A-2607653 (CLAUDE RICARD)<br>* revendication 1; figure 1 *<br>----- | 1, 6 | |

| DOMAINES TECHNIQUES RECHERCHES (Int. Cl.5 ) |
|---|
| H01R<br>H05K |

Le présent rapport a été établi pour toutes les revendications

| Lieu de la recherche | Date d'achèvement de la recherche | Examinateur |
|---|---|---|
| LA HAYE | 13 DECEMBRE 1989 | RIEUTORT A.S. |